(19) Europäisches Patentamt
European Patent Office
Office européen des brevets

(11) EP 4 329 194 A1

(12) EUROPEAN PATENT APPLICATION

(43) Date of publication:
28.02.2024 Bulletin 2024/09

(51) International Patent Classification (IPC):
H03F 3/45 (2006.01)

(21) Application number: 23190335.2

(22) Date of filing: 08.08.2023

(52) Cooperative Patent Classification (CPC):
H03F 3/45475; H03F 3/45928; H03F 3/45959;
H03F 3/45968; H03F 3/45982; H03F 2200/234;
H03F 2200/261; H03F 2203/45078;
H03F 2203/45134; H03F 2203/45138;
H03F 2203/45418; H03F 2203/45528;
H03F 2203/45588

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 25.08.2022 US 202217895372

(71) Applicant: Harman International Industries,
Incorporated
Stamford, CT 06901 (US)

(72) Inventors:
• DANYUK, Dimitri
  Stamford 06901 (US)
• SHIMIAEI, Danial
  Sherman Oaks 91403 (US)

(74) Representative: Rummler, Felix
Maucher Jenkins
Liebigstrasse 39
80538 München (DE)

(54) FULLY DIFFERENTIAL AMPLIFIER

(57) A fully differential amplifier (500) is provided. A first amplifying circuit (502) receives a first input voltage signal and provides a first output voltage signal. A second amplifying circuit (504) to receive a second voltage signal and to provide a second output voltage signal. A summing circuit (509) to provide a common mode component of the first input voltage signal and the second input voltage signal. A compensation circuit (540) to amplify the common mode component of the first input voltage signal and the second input voltage signal and output an injection signal. A common gain setting network (505) including a plurality of resistors to receive the injection signal and to interface with the first amplifying circuit (502), the second amplifying circuit (504), and the compensation circuit (540) to prevent the common mode component from being present in the first output voltage signal and the second output voltage signal.

Fig-5

EP 4 329 194 A1

**Description**

TECHNICAL FIELD

Aspects disclosed herein generally provide for, but not limited to, a fully differential amplifier. In one aspect, the fully differential amplifier may be implemented in an audio system or a method for providing an audio system. This aspect and others will be discussed in more detail herein.

BACKGROUND

One example of a differential amplifier includes a summing and feedback network for developing an output signal of which the magnitude is proportional to the differential mode component of an input signal received at first and second input terminals of an apparatus. The summing network is connected to the first and second input terminals and to the feedback network. A first differential amplifier has an inverting input connected to a first intermediate node of the summing network, and a second differential amplifier has an inverting input connected to the second intermediate node of the summing network. A bridging resistor is connected between the inverting inputs of the first and second differential amplifiers.

SUMMARY

In at least one embodiment, a fully differential amplifier is provided. The fully differential amplifier includes a first amplifying circuit, a second amplifying circuit, a summing circuit, a compensation circuit, and a common-mode gain setting network. The first amplifying circuit is configured to receive a first input voltage signal and to provide first output voltage signal. The second amplifying circuit is configured to receive a second input voltage signal and to provide second output voltage signal. The summing circuit is configured to provide a common mode component of the first input voltage signal and the second input voltage signal. The compensation circuit is configured to amplify the common mode component of the first input voltage signal and the second input voltage signal and to output an injection signal. The common gain setting network includes a plurality of resistors to receive the injection signal, common gain setting network is configured to interface with the first amplifying circuit, the second amplifying circuit, and the compensation circuit to prevent the common mode component from being present in the first output voltage signal and the second output voltage signal based on at least splitting the injection signal with the plurality of resistors to provide a first injection signal to an inverting input of the first amplifying circuit and to provide a second injection signal to an inverting input of the second amplifying circuit.

In at least another embodiment, a fully differential amplifier is provided. The fully differential amplifier includes a first amplifying circuit, a second amplifying circuit, a third amplifying circuit, a fourth amplifying circuit, a common gain setting network, and a summing network. The first amplifying circuit is configured to receive a first input voltage signal and to provide first output voltage signal. The second amplifying circuit is configured to receive a second input voltage signal and to provide a second output voltage signal. The third amplifying circuit is configured to receive the first input voltage signal and to provide a third output voltage signal. The fourth amplifying circuit is configured to receive the second input voltage signal and to provide a fourth output voltage signal. The common gain setting network includes a plurality of resistors to receive an injection signal and is configured to interface with the first amplifying circuit and the second amplifying circuit. The summing network includes a plurality of resistors is configured to provide a first common mode component and a second common mode component and to provide a first compensation signal to an inverting input of the first amplifying circuit and a second compensation signal to an inverting input of the second amplifying circuit in response to receiving the third output voltage signal and the fourth output voltage signal to prevent the common mode component from being present in the first output voltage signal and the second output voltage signal.

In at least another embodiment, a fully differential amplifier is provided. The fully differential amplifier includes a first amplifying circuit, a second amplifying circuit, a summing circuit, a compensation circuit, and a common-mode gain setting network. The first amplifying circuit receives a first input voltage signal and provides a first output voltage signal. The second amplifying circuit to receive a second input voltage signal and to provide a second output voltage signal. The summing circuit to provide a common mode component of the first input voltage signal and the second input voltage signal. The compensation circuit to amplify the common mode component of the first input voltage signal and the second input voltage signal and output an injection signal. The common gain setting network including a plurality of resistors to receive the injection signal and to interface with the first amplifying circuit, the second amplifying circuit, and the compensation circuit to prevent the common mode component from being present in the first output voltage signal and the second output voltage signal based at least on splitting the injection signal with the plurality of resistors to provide a first injection signal to the first amplifying circuit and to provide a second injection signal to the second amplifying circuit.

BRIEF DESCRIPTION OF THE DRAWINGS

The embodiments of the present disclosure are pointed out with particularity in the appended claims. However, other features of the various embodiments will become more apparent and will be best understood by referring to the following detailed description in conjunction with the accompany drawings in which:

FIGURE 1 depicts one example of a fully differential amplifier;

FIGURE 2 depicts another example of a fully differential amplifier;

FIGURE 3 depicts another example of a fully differential amplifier;

FIGURE 4 depicts another example of a fully differential amplifier;

FIGURE 5 depicts a fully differential amplifier in accordance with an embodiment;

FIGURE 6 depicts a more detailed schematic of the fully differential amplifier in accordance with an embodiment;

FIGURE 7 depicts another fully differential amplifier in accordance with an embodiment; and

FIGURE 8 depicts a fully differential amplifier in accordance with an embodiment.

DETAILED DESCRIPTION

As required, detailed embodiments of the present invention are disclosed herein; however, it is to be understood that the disclosed embodiments are merely exemplary of the invention that may be embodied in various and alternative forms. The figures are not necessarily to scale; some features may be exaggerated or minimized to show details of particular components. Therefore, specific structural and functional details disclosed herein are not to be interpreted as limiting, but merely as a representative basis for teaching one skilled in the art to variously employ the present invention.

The disclosed fully differential amplifiers may provide for equal output voltages with an opposite polarity from the amplifier in addition to equal distortion and improved stability with unknown loads. In addition, the disclosed fully differential amplifier may be implemented with a common mode feedforward loop. The disclosed fully differential amplifier may be used in any number of dual differential amplifier applications, for example, driving analog to digital converters (ADCs), as a bridge amplifier, etc.

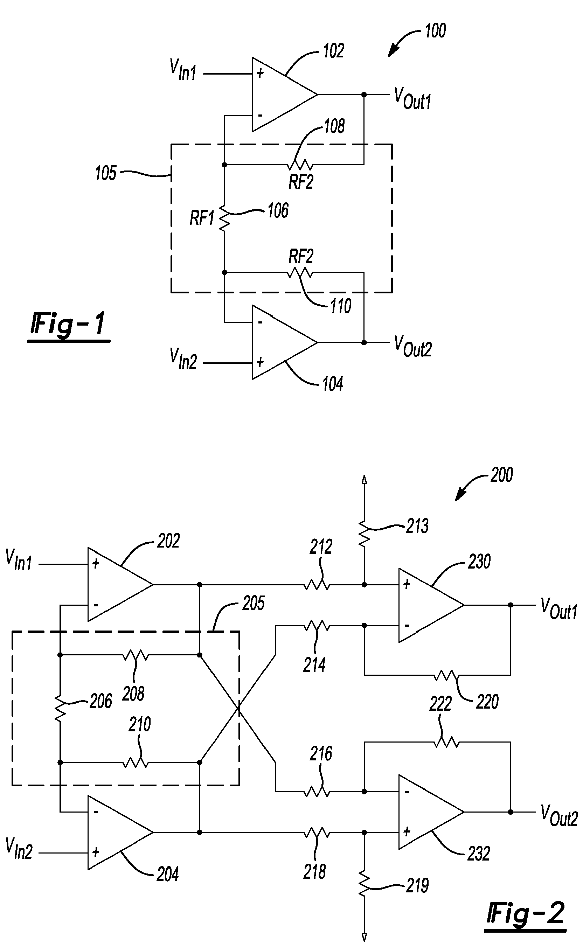

FIGURE 1 depicts one example of a fully differential amplifier (or amplifier) 100. The amplifier 100 includes a first amplifying circuit 102, a second amplifying circuit 104, and a common gain-setting feedback network 105. The common gain-setting feedback network 105 provides a voltage to inverting inputs of the first amplifying circuit 102 and the second amplifying circuit 104. The common gain-setting feedback network 105 includes resistors 106, 108, and 110. The resistors 106, 108, and 110 may have resistance values as defined by RF1 and RF2. Thus, in the regard, it may be seen that resistors 108 and 110 have similar resistance values. A first input voltage, VIn1 is applied to a non-inverting input of the first amplifying circuit 102, and a second input voltage, VIn2 is applied to a non-inverting input of the second amplifying circuit 104. The first amplifying circuit 102 provides a first voltage output (e.g., VOut1) and the second amplifying circuit 104 provides a second voltage output (e.g., VOut2).

In general, a differential-mode signal appears differentially on a pair of amplifier inputs (e.g., inputs to first and second amplifying circuits 102 and 104). A common mode signal appears equally (with respect to a local common terminal) on both amplifier inputs (e.g., inputs to first and second amplifying circuits 102 and 104). Usually, the common-mode signal is an undesired or unwanted signal that should be rejected by the differential amplifier 100. A common mode input voltage is generally expressed as an average of the two input voltages with respect to a local ground or common and may be shown as:

$$(VIn1 + VIn2)/2$$

The common gain setting feedback network 105 provides feedback to the first amplifying circuit 102 and the second amplifying circuit 104. In general, a gain of the first and second amplifying circuits 102 and 104 may be very high and uncontrollable. The common gain-setting feedback network 105 sets a differential gain that is defined by (resistor 108 (RF2) + resistor 110 (RF2))/ resistor 106 (RF1)). Alternatively, a differential gain may be defined by (VOut1 - VOut2) / (VIn1 - VIn2).

One property of the amplifier 100 is that a common mode gain for the first and the second amplifying circuits 102, 104 (e.g., the inputs provided to the non-inverting inputs of the first and second amplifying circuits 102 and 104) is equal to unity irrespective of the differential gain that is set by the resistors 106, 108, and 110. In general, a common mode rejection ratio is equal to the differential gain of the amplifier 100. The node voltages may be defined as follows:

$$(VOut1-VIn1) / RF2 = (VIn1-VIn2) / RF1 = (VIn2 - VOut2)/RF2,$$

then the differential gain
is given by:

$$(VOut1-VOut2)/(VIn1-VIn2) = 2*RF2/R1+1$$

and the common mode gain is given by:

$$(VOut1+VOut2)/(VIn1+VIn2 )= 1$$

The output voltage VOut1 may depend not only on a differential voltage VIn1 - VIn2, but also on the common mode input voltage, (VIn1 + VIn2)/2. In general, it is not desirable for the amplifier 100 to pass a common mode signal (e.g., or the common mode input voltage (e.g., (VIn1 + VIn2)/2) through the first and the second amplifying circuits 102 and 104)). While the amplifier 100 may have some advantages, the amplifier may not reject the common mode input voltage. It may be desirable to reject or prevent the common mode input voltage from being present on the output signals (e.g., VOut1 and VOut2).

FIGURE 2 depicts another example of a fully differential amplifier 200. The differential amplifier 200 may be implemented in the form of an instrumentation amplifier. The amplifier 200 includes a first amplifying circuit 202, a second amplifying circuit 204, a third amplifying circuit 230, a fourth amplifying circuit 232, and a common gain-setting feedback network 205. The common gain-setting network 205 provides a voltage input to an inverting input of the first amplifying circuit 202 and the second amplifying circuit 204. The first and second amplifying circuits 204 provide a voltage output to the inputs of the third amplifying circuit 230 and the fourth amplifying circuit 232. The common gain-setting feedback network 205 includes resistors 206, 208, and 210. A first input voltage, VIn1 is applied to a non-inverting input of the first amplifying circuit 202, and a second input voltage, VIn2 is applied to a non-inverting input of the second amplifying circuit 204. The fully differential amplifier 200 further includes resistors 212, 213, 214, 216, 218, 219, 220, and 222. The third and the fourth amplifying circuits 230, 232 along with the resistors 212, 213, 214, 216, 218, 219, 220, and 222 operate as a single-ended differential amplifiers and may suppress the residual common mode signal (e.g., (VIn1 + VIn2)/2) as output from the first amplifier 202. The amplifiers 230 and 232 may fully suppress the common mode. However, the amplifier 200 requires additional components (e.g., the amplifier 230 along with the resistors 212, 213, 214, and 220 and the amplifier 232 along with the resistors 216, 218, 219, 222). These additional resistors for each the amplifiers 230 and 232 increase the overall cost of the amplifier.

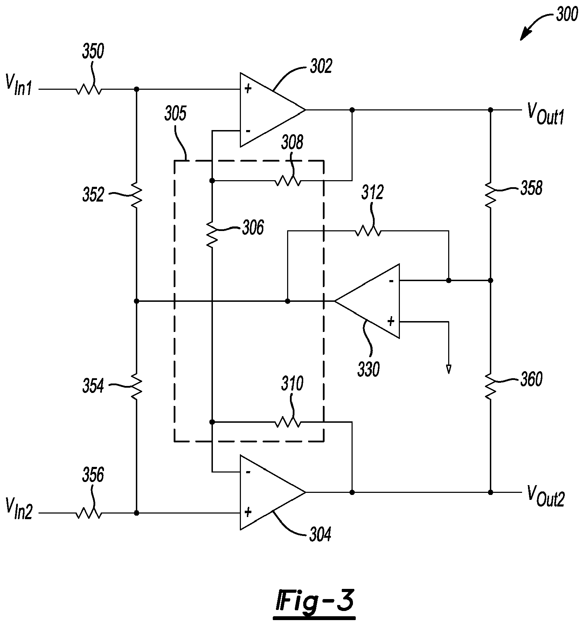

FIGURE 3 depicts another example of a fully differential amplifier 300. The amplifier 300 generally includes a first amplifying circuit 302, a second amplifying circuit 304, a compensation amplifier 330, and a common gain-setting feedback network 305. The common gain-setting network 305 provides a voltage input to an inverting input of the first amplifying circuit 302 and the second amplifying circuit 304. The common gain-setting feedback network 305 includes resistors 306, 308, and 310. In addition, the amplifier 300 further includes resistors 352, 354, 358, and 360.

In general, the output signals (e.g., VOut1 and VOut2) of the amplifier 300 are applied through the resistors 358 and 360 to the inverting input of the compensation amplifier 330. Such resistors 358 and 360 may have similar resistance values. The resistor 312 may be implemented as a gain-setting resistor to provide feedback from the output of the compensation amplifier 330 to the inverting input thereof. The compensation amplifier 330 compares the input voltage received on the inverting input with zero. The amplified difference from the output of the compensation amplifier 330 is applied through the resistors 352 and 354 to non-inverting inputs of the amplifying circuits 302 and 304 in the opposite phase to the common mode input signal. Since such an opposing voltage creates a negative common mode feedback signal, this condition may eliminate input common mode voltage on an output of the first and second amplifying circuits 302, 304. The amplifier 300 provides a common mode feedback loop to suppress at least a portion of the common mode component (e.g., at least a portion of (VIn1 + VIn2)/2)) in the output signals (e.g., VOut1 or VOut2).

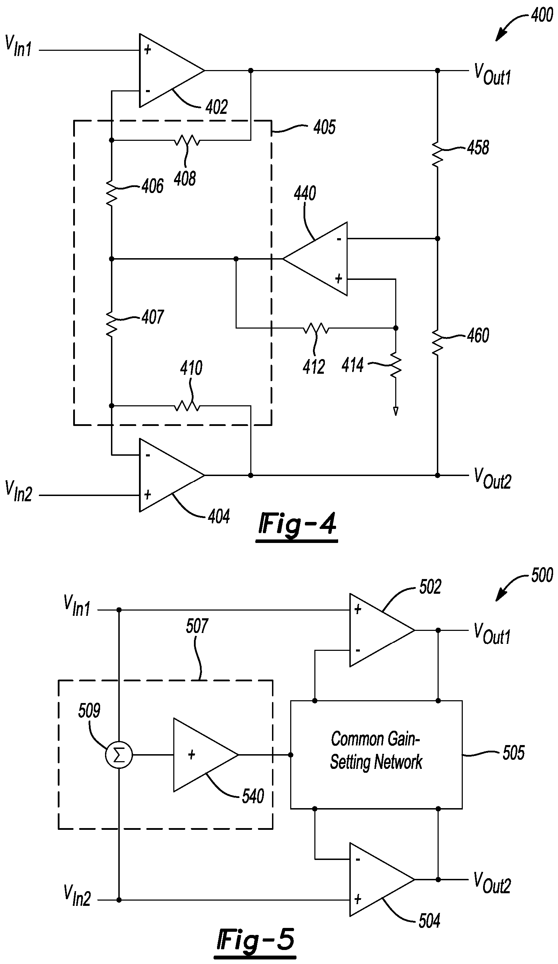

FIGURE 4 depicts another example of a fully differential amplifier 400. The amplifier 400 generally includes a first amplifying circuit 402, a second amplifying circuit 404, a compensation amplifier 440, and a common gain-setting feedback network 405. The common gain-setting feedback network 405 provides a voltage input to an inverting input of the first amplifying circuit 402 and to an inverting input of the second amplifying circuit 404-. The common gain-setting network 405 includes resistors 406, 407, 408, 410. In addition, the amplifier 400 further includes resistors 412, 414, 458 and 460. The amplifier 400 provides a common mode feedback loop to also suppress at least a portion the common mode component (e.g., (VIn1+VIn2)/2) in the output signals that are present in the output signal, VOut1 and VOut2, respectively) and a common mode feedback signal superimposed with the input signal.

In general, the output signals (e.g., VOut1 and VOut2) are applied through equal-valued resistors 458 and 460 to the non-inverting input of the compensation amplifier 440. The resistors 458 and 460 may have a similar resistance value as one another. The resistors 412 and 414 may set a common mode gain. The output signal of the compensation amplifier 440 is injected in the common gain-setting feedback network 405. The compensation amplifier 440 compares a sum of the output voltages (e.g., VOut1 and VOut2) to zero. An output of the compensation amplifier 440 may then be transferred through the resistors 406 and 407 to the inverting inputs of the first and the second amplifying circuits 402 and 404. This aspect may create a negative common mode signal feedback path thereby eliminating the common mode input signal of the first and the second amplifying circuits 402 and 404. The resistors 406 and 407 may have a similar resistance value as one another.

The degree of common mode rejection on the output of the compensation amplifier 440 depends on, for example, the gain of the compensation amplifier 440, matching of the component values (or resistors), and matching of the gain of the main amplifying paths. The degree of matching of the main amplifying paths depends upon the loads parameters that can be unpredictable. Unmatched load values can add uncontrollable differential component to the input of the compensation amplifier 440. It may be desirable to provide a fully differential gain amplifier circuit that is not sensitive to load matching and does not include a large number of amplifying circuits in the signal path.

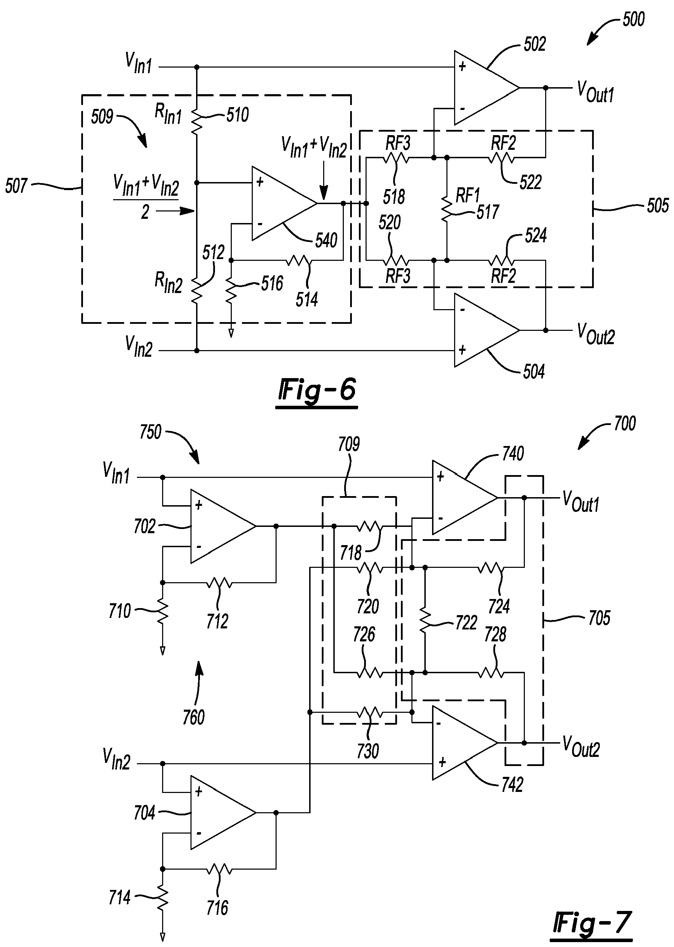

FIGURE 5 depicts a fully differential amplifier 500 in accordance with an embodiment. The amplifier 500 includes a first amplifying circuit 502, a second amplifying circuit 504, a common gain-setting network 505, and a compensation circuit 507 in accordance with one embodiment. The compensation circuit 507 includes a summing network 509 and a compensation amplifier 540. In general, the compensation circuit 507 detects or senses the common mode input signal $(((VIn1 + VIn2)/2))$ as provided to non-inverting inputs of the first and second amplifying circuits 502 and 504, respectively. The compensation circuit 507 injects a signal into the gain-setting network 505. A resultant signal from the compensation circuit 507 is provided to the common gain setting network 505 in such manner that a final result of the common mode input signal (or component) $(((VIn1 + VIn2)/2))$ in the output signals (e.g., VOut1 and VOut2) is zero. The common mode signal input (e.g., $(VIn1 + VIn2)/2$) is provided as an input to the compensation amplifier 540 (see FIGURE 6). Similarly, the compensation amplifier 540 provides a signal as an output that may be defined as $VIn1 + VIn2$ (see FIGURE 6). The common gain-setting network 505 provides gain setting to the inverting inputs of the first amplifying circuit 502 and the second amplifying circuit 504. Prior implementations may inject the common mode input signal (e.g., $(VIn1 + VIn2)/2$) on the output (e.g., VOut1 or VOut2) and inject the common mode signal to a feedback gain setting circuit. With the embodiment illustrated in FIGURE 5, the common mode input signal (e.g., $(VIn1 + VIn2)/2$) may be sensed directly at the input of the amplifier 500 (or prior to such signals being received at the first and the second amplifying circuits 502, 504) and then injected into the common gain setting network 505.

FIGURE 6 depicts a more detailed schematic of the fully differential amplifier 500 of FIGURE 5 in accordance with an embodiment. For example, the summing network 509 of the compensation circuit 507 includes resistors 510, 512. The resistors 510 and 512 may have resistance values defined by RIn1 and RIn2. The compensation circuit 507 further includes resistors 514 and 516 coupled to an inverting input of the compensation amplifier 540. The common gain-setting network 505 includes resistors 517, 518, 520, 522, and 524. The resistors 517, 518, 520, 522, and 524 may have resistance values as defined by RF1, RF2, or RF3. Thus, in the regard, it may be seen that resistors 522 and 524 have similar resistance values (e.g., RF2) and that resistors 518 and 520 have similar resistance values (e.g., RF3). The common gain-setting network 505 provides an input to the inverting inputs of the first and the second amplifying circuits 502, 504. A resultant signal from the compensation circuit 507 is provided to the common gain setting network 505 in such manner that a final result of the common mode input signal (or component) $(((VIn1 + VIn2)/2))$ in the output signals (e.g., VOut1 and VOut2) is zero based on the values of the resistors 517, 518, 520, 522, and/or 524 (or the resistance values RF2 and RF3).

The input signals (e.g., VIn1 and VIn2) are applied to the non-inverting inputs of the first and the second amplifying circuits 502, 504, respectively in addition to the resistors 510, 512, respectively of the summing network 509. The compensation amplifier 540 amplifies an output provided by the summing network 509 (e.g., the resistors 514 and 516) to generate an amplified output. The compensation amplifier 540 provides (or injects) the amplified output into the common gain setting network 505. The voltage on the noninverting input of the compensation amplifier 540 may be written as VIn1 minus a voltage drop on the resistor 510, or $VIn1 - (VIn1-VIn2)*RIn1/(RIn1 + RIn2)$, where $(VIn1 - VIn2)/(RIn1 + RIn2)$ is a current that flows through the resistors 510 and 512 that are in series with one another.

In general, $VIn1-(VIn1-VIn2) * RIn1/(RIn1 + RIn2)$ may be simplified as $(VIn1* RIn2 + Vin2*RIn1)/(RIn1 + RIn2)$ and assuming $RIn1 = RIn2$ then $(VIn1+VIn2)/2$. The first and the second amplifying circuits 502 and 504 each have a large open loop gain, so the input signal between their inputs is negligible (e.g., near zero). For the first amplifying circuit 502 amplifier the following equation can be written:
(VOut1 - VIn1)/RF2 = (VIn1-VIn2)/RF1 + (VIn1 - VIn1 -VIn2)/RF3, thus the sum of the currents through the resistors 522 is equal to the sum of the current through the resistors 517 and 518.

The following may be derived from the equations noted above in connection with the first amplifying circuit 502:

$$(VOut1-VIn1)/RF2 = (VIn1-VIn2)/RF1 + (VIn1-VIn1-VIn2)/RF3;$$

or

$$VOut1 = RF2(VIn1(1/RF1+1/RF2) - VIn2(1/RF1+1/RF3)).$$

Assuming that if RF2 = RF3, then VOut1 = (RF2/RF1+1) (VIn1-VIn2); if VIn1 = VIn2 then VOut1=0

The same set of equations may be written for the second amplifying circuit 504:

$$(VOut2-VIn2)/RF2 = (VIn2 - VIn1)/RF1 + (VIn2 - VIn1 - VIn2)/RF3;$$

or

$$VOut2 = RF2(VIn2(1/RF1+1/RF2) - VIn1(1/RF1 + 1/RF3)).$$

If RF2 = RF3, then VOut2 = (RF2/RF1+1) (VIn2 - VIn2); if VIn1 = VIn2 then VOut2=0

$$VOut2=(RF2/RF1+1)(VIn2-VIn1),$$

differential gain is given by:

$$(VOut1 - VOut2) / (VIn1 - VIn2) = 2*RF2/RF1+1$$

and
the common mode gain is given by:

$$(VOut1 + VOut2) / (VIn1 + VIn2) = 0$$

These equations (or balance equations) illustrate that (VIn1+VIn2)/2 (or the common mode component) is not present in the output signal (e.g., (VOut1 or VOut2)) which is the desired result.

Thus, exhibited above, VOut1 (or the output voltage) may generally depend on the differential voltage which is defined by VIn1 - VIn2. The function of the differential amplifier 500 is to amplify the difference (e.g., VIn1 - VIn2) and suppress the common mode component (e.g., VIn1 + VIn2)/2).

In operation and based at least on the above passages disclosed above, the first amplifying circuit 502 receives a first input voltage signal (e.g., VIn1) and provides a first output voltage signal (e.g., VOut1). The second amplifying circuit 504 receives a second voltage signal (e.g., VIn2) and provides second output voltage signal (e.g., VOut2). The summing network 509 provides the common mode component (e.g., (VIn1+VIn2)/2) of the first input voltage signal and the second input voltage signal. The compensation amplifier 540 is configured to amplify the common mode component of the first input voltage signal and the second input voltage signal and output an injection signal. The common gain setting network 505 includes a plurality of resistors (e.g., 517, 518, 520, 522, 524) to receive the injection signal and being configured to interface with the first amplifying circuit 502, the second amplifying circuit 504 and the compensation amplifier 540 to prevent the common mode component from being present in the first output voltage signal and the second output voltage signal (e.g., VOut2) based on at least splitting the injection signal with the plurality of resistors (e.g., 517, 518, 520, 522, 524) to provide a first injection signal to an inverting input of the first amplifying circuit 502 and to provide a second injection signal to an inverting input of the second amplifying circuit 504.

The resistor 518 receives the first injection signal and the resistor 520 receives the second injection signal. A first resistance value of the resistors 518, 520 are similar to one another. An output from the resistor 518 is transmitted to the inverting input of the first amplifying circuit 502. The resistor 520 is transmitted to the inverting input of the second amplifying circuit 504.

The resistor 522 receives an output from the resistor 518 and the resistor 524 receives an output from the second resistor 520. A second resistance value of the resistors 522 and 524 are similar to one another. The first resistance value of the resistors 518 and 520 is similar to the second resistance value of the resistors. The resistor 517 generally sets the differential gain (e.g., (Vout1 - Vout2/Vin1 - Vin2) for the amplifier 500. The differential gain is independent from the common mode component.

FIGURE 7 depicts another fully differential amplifier (or amplifier) 700 in accordance with another embodiment. The amplifier 700 includes a first amplifying circuit 702, a second amplifying circuit 704, a common gain-setting network 705, a third amplifying circuit 740 and a fourth amplifying circuit 742. The common gain-setting network 705 provides a voltage input to an inverting input of the first amplifying circuit 702, the second amplifying circuit 704, the third amplifying circuit 740, and the fourth amplifying circuit 742. The amplifier 700 includes resistors 710, 712, 714, 716, 718, and 720. The common gain-setting network 705 includes resistors 722, 724, and 728. The resistors 718, 720, 726, and 730 for a summing network 709. The summing network 709 performs the summing function of the outputs from the third and the fourth amplifying circuits 740, 742. In this regard, the summing function is performed prior to the amplification by the resistors 510, 512 in reference to FIGURE 5. For example, the amplifier 700 does not include the summing network 709 on the input of the amplifier 700. Therefore, the amplifier 700 provides a high input resistance.

In one example, there may be three building blocks in series in the common mode feedforward path. This may involve a summing network, an amplifier circuit with associated components and an injection circuit. The difference between common mode path as illustrated for the amplifier 500 in connection with FIGURE 6 and the amplifier 700 of FIGURE 7 is in the particular order in which building blocks follow each other.

The amplifier 700 of FIGURE 7 is similar to the amplifier 500 of FIGURE 6 in that the amplifier 700 utilizes the summing network 709 and an amplifying stage 750 (e.g., first and second amplifying circuits 702 and 704). The summing network 709 may also be referred to as an injecting stage. Thus, the summing network 709 performs both summing and injecting functions. In general, the amplifying state, the injecting stage, and the summing stage may be arranged in any order. The common gain-setting network 705 sets the gain for the third and fourth amplifier circuits 740 and 742 and the summing network 709 as positioned after the amplifying stage 750 maintains a high input resistance (or high impedance).

In operation and based at least on the above passages disclosed above, the third amplifying circuit 740 receives the first input voltage signal (e.g., VIn1) and provides a first output voltage signal (e.g., VOut1). The fourth amplifying circuit 742 receives the second voltage signal (e.g., VIn2) and provides the second output voltage signal (e.g., Vout2). The first amplifying circuit 702 receives the first input voltage signal (e.g., VIn1) and provides a third output voltage signal. The second amplifying circuit 704 configured to receive configured to receive the second input voltage signal (e.g., VIn2) and provide a fourth output voltage signal. The common gain setting network 705 include the resistors 722, 724, 728 to receive an injection signal. The common gain setting network 705 interfaces with the first amplifying circuit 740, the second amplifying circuit 704. The summing network 709 includes the resistors 718, 720, 726, 730 and is configured to provide a first common mode component and a second common mode component and to provide a first compensation signal to an inverting input of the third amplifying circuit 740 and a second compensation signal to an inverting input of the fourth amplifying circuit 742 in response to receiving the third output voltage signal and the fourth output voltage signal to prevent a first common mode component from being present in the first output voltage signal and a second common mode component from being present in the second output voltage signal.

The resistor 718 receives the third output voltage signal and the resistor 720 receives the fourth output voltage signal. A first resistance value of the resistors 718 and 720 are similar to one another. The resistor 718 transmits an output and the resistor 720 transmits an output to the inverting input of the third amplifying circuit 740.

The resistor 726 receives the third output voltage signal and the resistor 730 receives the fourth output voltage signal. A second resistance value of the resistors 726, 730 are similar to one another.

The resistor 720 transmits an output and the resistor 730 transmits an output to the inverting input of the fourth amplifying circuit 742. The first resistance value of the resistors 718 and 720 is similar to the second resistance value of the resistors 726, 730. The resistor 722 sets a differential gain (Vout1 - Vout2)/(Vin1 - Vin2) for the amplifier 700 and the differential gain is independent from the common mode component.

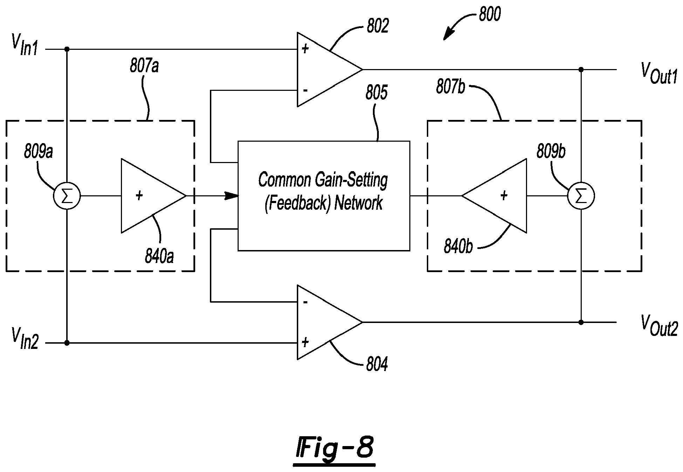

FIGURE 8 depicts a fully differential amplifier 800 in accordance with an embodiment. The amplifier 800 includes a first amplifying circuit 802, a second amplifying circuit 804, a gain-setting network 805, a first compensation circuit 807a, and a second compensation circuit 807b. The first compensation circuit 807a includes a first summing network 809a and a first compensation amplifier 840a. The second compensation circuit 807b includes a second summing network 809b and a second compensation amplifier 840b.

The first compensation circuit 807a detects or senses common mode signals (or inputs VIn1 and VIn2) as provided to non-inverting inputs of the first and second amplifying circuits 802 and 804, respectively. The first compensation circuit 807a injects a signal into the gain-setting network 805. A resultant signal from the first compensation circuit 807a is provided to the gain setting network 805 in such manner that a final result of the common mode component (e.g (VIn 1 + VIn2)/2) in the output signals (e.g., VOut1, VOut2) is zero. Similar to that noted above, the common mode component (or common mode input signal) may be defined as (VIn1 + VIn2)/2 and is provided as an input to the first compensation circuit 807a. While the first compensation circuit 807a may effectively remove a substantial portion of the common mode input signal, the second compensation circuit 807b may suppress any residual common mode components that may be-presented on the amplifier output terminals after operation of the first compensation circuit 807a.

The amplifier 800 generally utilizes an additional common mode suppression path (e.g., the first compensation circuit 807a) along with a common mode feedback path (e.g., the second compensation circuit 807b). This may provide better suppression of the common mode component (e.g., (VIn1 + VIn2)/2 in the output signal (e.g., VOut1, VOut2) and/or provide relaxed requirements for signal path component (e.g., resistor) tolerances.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

**Claims**

1. A fully differential amplifier comprising:

   a first amplifying circuit configured to receive a first input voltage signal and to provide first output voltage signal;
   a second amplifying circuit configured to receive a second input voltage signal and to provide second output voltage signal;
   a summing circuit configured to provide a common mode component of the first input voltage signal and the second input voltage signal;
   a compensation circuit configured to amplify the common mode component of the first input voltage signal and the second input voltage signal and to output an injection signal, and
   a common gain setting network including a plurality of resistors to receive the injection signal, the common gain setting network is configured to interface with the first amplifying circuit, the second amplifying circuit and the compensation circuit to prevent the common mode component from being present in the first output voltage signal and the second output voltage signal based on at least splitting the injection signal with the plurality of resistors to provide a first injection signal to an inverting input of the first amplifying circuit and to provide a second injection signal to an inverting input of the second amplifying circuit.

2. The fully differential amplifier of claim 1, wherein the plurality of resistors includes a first resistor to receive the first injection signal and a second resistor for receiving the second injection signal, wherein a first resistance value of the first resistor and the second resistor are similar to one another.

3. The fully differential amplifier of claim 2, wherein an output from the first resistor is transmitted to the inverting input of the first amplifying circuit, and wherein an output from the second resistor is transmitted to the inverting input of the second amplifying circuit.

4. The fully differential amplifier of claim 2 or 3, wherein the plurality of resistors includes a third resistor to receive an output from the first resistor and a fourth resistor for receiving an output from the second resistor, and wherein a second resistance value of the third resistor and the fourth resistor are similar to one another.

5. The fully differential amplifier of claim 4, wherein the first resistance value is similar to the second resistance value.

6. The fully differential amplifier of any preceding claim, wherein the plurality of resistors includes a first resistor that sets a differential gain.

7. The fully differential amplifier of claim 6, wherein the differential gain is independent from the common mode component.

8. A fully differential amplifier comprising:

a first amplifying circuit configured to receive a first input voltage signal and provide first output voltage signal;
a second amplifying circuit configured to receive a second input voltage signal and to provide second output voltage signal;
a third amplifying circuit configured to receive configured to receive the first input voltage signal and provide a third output voltage signal;
a fourth amplifying circuit configured to receive the second input voltage signal and provide fourth output voltage signal;
a common gain setting network including a plurality of resistors to receive an injection signal and configured to interface with the first amplifying circuit and the second amplifying circuit, and
a summing network includes a plurality of resistors configured to:

provide a first common mode component and a second common mode component; and
provide a first compensation signal to an inverting input of the first amplifying circuit

and a second compensation signal to an inverting input of the second amplifying circuit in response to receiving the third output voltage signal and the fourth output voltage signal to prevent the first common mode component from being present in the first output voltage signal and the second common mode component from being present in the second output voltage signal.

9. The fully differential amplifier of claim 8, wherein the plurality of resistors includes a first resistor to receive the third output voltage signal and a second resistor to receive the fourth output voltage signal, wherein a first resistance value of the first resistor and the second resistor is similar to one another.

10. The fully differential amplifier of claim 9, wherein an output from the first resistor and an output from the second resistor is transmitted to is transmitted to the inverting input of the first amplifying circuit.

11. The fully differential amplifier of claim 9 or 10, wherein the plurality of resistors includes a third resistor to receive the fourth output voltage signal and a fourth resistor to receive the fourth output voltage signal, wherein a second resistance value of the third resistor and the fourth resistor is similar to one another.

12. The fully differential amplifier of claim 11, wherein an output from the third resistor and an output from the fourth resistor is transmitted to the inverting input of the second amplifying circuit.

13. The fully differential amplifier of claim 12, wherein the first resistance value is similar to the second resistance value.

14. The fully differential amplifier of any of claims 8 to 13, wherein the plurality of resistors includes a first resistor that sets a differential gain.

15. The fully differential amplifier of claim 14, wherein the differential gain is independent from the first common mode component and the second common mode component.

_100_

_Fig-1_

$V_{In1}$

102

$V_{Out1}$

105

108

RF2

RF1 106

RF2

110

$V_{In2}$

104

$V_{Out2}$

_200_

_Fig-2_

$V_{In1}$

202

213

212

230

205

$V_{Out1}$

214

206 208

210

216

222 220

$V_{In2}$

204

218

219

232

$V_{Out2}$

_Fig-3_

_Fig-4_

_Fig-5_

_Fig-6_

_Fig-7_

$V_{In1}$

$V_{Out1}$

807a

802

805

807b

809a

809b

Common Gain-Setting
(Feedback) Network

840a

840b

$V_{In2}$

$V_{Out2}$

804

800

## Fig-8

# EUROPEAN SEARCH REPORT

Europäisches
Patentamt
European
Patent Office
Office européen
des brevets

**Application Number**

EP 23 19 0335

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/114834 A1 (KONINKL PHILIPS ELECTRONICS NV [NL]; FREEKE ARNOLD J [NL]) 1 December 2005 (2005-12-01) * page 1, line 1 - page 11, line 20; figures 1-10 * | 1-15 | INV. H03F3/45 |
| X | "A balanced line mixing and distribution amplifier", ELECTRONIC ENGINEERING, MORGAN-GRAMPIAN LTD. LONDON, GB, vol. 48, no. 581, 1 July 1976 (1976-07-01) , pages 25-27, XP001109422, ISSN: 0013-4902 | 1-7 | |
| A | * page 25, column 1, line 39 - page 26, column 1, line 38; figure 1 * | 8-15 | |
| A | US 4 571 554 A (MARTIN HARDISON G [US] ET AL) 18 February 1986 (1986-02-18) * column 1, line 8 - column 4, line 33; figures 1,2 * | 1-15 | |

**TECHNICAL FIELDS SEARCHED (IPC)**

H03F

The present search report has been drawn up for all claims

| Place of search | Date of completion of the search | Examiner |
|---|---|---|
| The Hague | 9 January 2024 | Fedi, Giulio |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 19 0335

This annex lists the patent family members relating to the patent documents cited in  the above-mentioned European search report.
The members are as contained in the European Patent Office EDP file on
The European Patent Office is in no way liable for these particulars which are merely given for the purpose of information.

09-01-2024

| Patent document cited in search report | | Publication date | Patent family member(s) | | Publication date |
|---|---|---|---|---|---|
| WO 2005114834 | A1 | 01-12-2005 | CN | 1993883 A | 04-07-2007 |
| | | | EP | 1763922 A1 | 21-03-2007 |
| | | | JP | 2007538449 A | 27-12-2007 |
| | | | US | 2007241813 A1 | 18-10-2007 |
| | | | WO | 2005114834 A1 | 01-12-2005 |
| US 4571554 | A | 18-02-1986 | NONE | | |

EPO FORM P0459

For more details about this annex : see Official Journal of the European Patent Office, No. 12/82